# EUROPÄISCHE PATENTSCHRIFT

(11) **EP 1 212 583 B1**
(45) Veröffentlichungstag und Bekanntmachung des Hinweises auf die Patenterteilung: **28.05.2003**
(21) Anmeldenummer: 00962234.1
(22) Anmeldetag: 22.08.2000
(51) Int. Cl.: G01B 11/24

(54) **EINRICHTUNG ZUR INSPEKTION EINER DREIDIMENSIONALEN OBERFLÄCHENSTRUKTUR**
DEVICE FOR INSPECTING A THREE-DIMENSIONAL SURFACE STRUCTURE
DISPOSITIF POUR INSPECTER UNE STRUCTURE SUPERFICIELLE TRIDIMENSIONNELLE

(30) Priorität: 13.09.1999 DE 29916075 U
(43) Veröffentlichungstag der Anmeldung: 12.06.2002
(73) Patentinhaber: SIEMENS AKTIENGESELLSCHAFT, 80333 München (DE)
(72) Erfinder: BELLM, Hubert, D-76297 Stutensee-Blankenloch (DE); KANT, Dieter, D-76287 Rheinstetten (DE)
(86) Internationale Anmeldenummer: DE0002855
(87) Internationale Veröffentlichungsnummer: WO01020255

(56) Entgegenhaltungen:
- EP-A- 0 403 908
- EP-A- 0 866 308
- DE-A- 19 608 468
- US-A- 3 902 811
- US-A- 5 619 587

## Beschreibung

Die Erfindung betrifft eine Einrichtung zur Inspektion einer dreidimensionalen Oberflächenstruktur nach dem Oberbegriff des Anspruchs 1.

Eine derartige Einrichtung zur Inspektion einer dreidimensionalen Oberflächenstruktur ist bereits aus der DE 196 08 468 C2 bekannt. Sie ist geeignet zur Inspektion einer dreidimensionalen Oberflächenstruktur eines im wesentlichen ebenen Prüflings, insbesondere zur Inspektion des Lotpastendrucks auf Leiterplatten. Mit einem optischen Sensor wird ein Teilbereich der Oberfläche des Prüflings dreidimensional erfaßt. Eine Positioniereinrichtung dient zur relativen Positionierung des optischen Sensors zum Prüfling, damit nacheinander verschiedene Teilbereiche der Oberfläche inspiziert werden können.

Ein Anwendungsgebiet, in welchem die bekannte Inspektionseinrichtung vorteilhaft eingesetzt werden kann, ist die Inspektion des Lotpastendrucks auf Leiterplatten. Um zu vermeiden, daß potentielle Lötfehler durch die gesamte Prozeßkette in der Fertigung elektronischer Flachbaugruppen weitergeleitet und später mit hohem Aufwand repariert werden müssen, ist eine ständige Überwachung des Lotpastendrucks erforderlich. Fehler, die vom Siebdruck verursacht werden, können so vor dem Bestücken der Leiterplatte mit Bauelementen erkannt und fehlerhafte Leiterplatten noch vor dem Entstehen weiterer Kosten ausgesondert werden. Leiterplatten für oberflächenmontierbare Bauelemente, sogenannte Leiterplatten in Surface-Mount-Technology (SMT), werden in großen Stückzahlen und vielen Varianten produziert. Die oberflächenmontierbaren Bauelemente werden auf der Leiterplatte durch Verlöten ihrer Anschlüsse auf metallisierten Flächen, sogenannten Pads, mechanisch gehalten und elektrisch mit Leiterzügen auf der Leiterplatte verbunden. Dazu ist auf der Leiterplatte ein Muster von metallischen Pads vorgesehen, das zur Lage der Anschlüsse des Bauelements korrespondiert. Mit einem Siebdruckverfahren wird auf die Pads Lotpaste aufgetragen. Danach wird das oberflächenmontierbare Bauelement auf die Leiterplatte bestückt. Zunächst wird das Bauelement durch die Klebeeigenschaft der Lotpaste auf der Leiterplatte gehalten. Nach einem anschließenden Erhitzen der bestückten Leiterplatte sind die Anschlüsse des Bauelements mit den Pads fest verlötet.

In der Aufbautechnik ist ein Trend zu immer höherer Integration der Bauelemente mit einer wachsenden Anzahl von Anschlüssen je Bauelementegehäuse erkennbar. Im sogenannten Fine-Pitch-Bereich beträgt der Abstand zwischen zwei nebeneinanderliegenden Anschlüssen eines Bauelements etwa 0.0635 cm (1/40 Zoll). Damit werden auch die Pads auf den Leiterplatten kleiner und dichter. Etwa 80 % der Lötfehler werden im Fine-Pitch-Bereich durch den Lotpastendruck verursacht. Beispiele für derartige Fehler sind ein zu geringer Lotpastenauftrag oder Kurzschlüsse zwischen benachbarten Pads durch ungenaue Plazierung der Siebdruckschablone beim Lotpastendruck. Um diese Fehler zu finden und Schwachstellen im Fertigungsprozeß aufzudecken, wird nach dem Lotpastenauftrag eine optische Inspektion der Leiterplatte vorgenommen.

In der deutschen Patentanmeldung mit dem amtlichen Akten-zeichen DE-A- 199 15 052 (veröffentlicht am 5.10.00) wurde eine Einrichtung zur Inspektion einer dreidimensionalen Oberflächenstruktur sowie ein Verfahren zur Kalibrierung einer derartigen Einrichtung vorgeschlagen. Diese Inspektionseinrichtung zeichnet sich durch eine verbesserte Genauigkeit der Vermessung von dreidimensionalen Oberflächenstrukturen aus. Es ist angegeben, daß die Koordinaten der zu inspizierenden Merkmale, insbesondere der Lotdepots bei Leiterplatten, aus den Bestückdaten der Bauelemente, die nach einem CAD-Entwurf der Baugruppe üblicher-weise als elektronische Datei vorliegen, abgeleitet werden können. Nachteilig ist, daß der Anwender Grenzwerte für geometrische Eigenschaften oder Merkmale des Lotpastenauftrags manuell ausrechnen und mit einer Tastatur an der Inspektionseinrichtung eingeben muß. Zudem erfolgen Anpassungen während eines Einrichtvorgangs ebenfalls mittels manueller Eingabe von Zahlen durch den Anwender. Diese Arbeiten gestalten sich sehr zeitaufwendig und damit kostenintensiv. Weitere optische Einrichtungen zur Inspektion von Oberflächenstrukturen sind z.B. in US 3 902 811 und EP 0 866 308 vorgeschlagen.

Der Erfindung liegt die Aufgabe zugrunde, eine Einrichtung zur Inspektion einer dreidimensionalen Oberflächenstruktur zu schaffen, bei welcher die Festlegung der Grenzwerte, auf deren Einhaltung gemessene Werte geometrischer Eigenschaften einer inspizierten Oberflächenstruktur geprüft werden, für den Bediener vereinfacht wird.

Zur Lösung dieser Aufgabe weist die neue Einrichtung der eingangs genannten Art die im kennzeichnenden Teil des Anspruchs 1 angegebenen Merkmale auf. In den Unteransprüchen sind vorteilhafte Weiterbildungen beschrieben.

Die Erfindung hat den Vorteil, daß die Festlegung der Grenzwerte einen erheblich geringeren Zeitaufwand erfordert und somit eine Inspektion des Lotpastendrucks auf Leiterplatten geringere Kosten verursacht. Die Berechnung der Grenzwerte geometrischer Eigenschaften des Lotpastenauftrags erfolgt durch ein Programm, das im Steuerrechner der Inspektionseinrichtung integriert sein kann. Der Anwender muß keinerlei manuelle Berechnungen mehr ausführen.

Die Erfindung ist insbesondere bei der Prüfung des Lotpastenauftrags auf einer Leiterplatte vorteilhaft anwendbar, da hier viele verschiedene geometrische Eigenschaften zu prüfen und somit viele verschiedene Grenzwerte zu berechnen sind.

In vorteilhafter Weise wird ein Verfolgen des Prüfprogrammablaufs und der Ergebnisse der einzelnen Prüfschritte für den Bediener ermöglicht, wenn Mittel zur Ausgabe der gemessenen Werte der geometrischen Eigenschaften einer inspizierten Oberflächenstruktur an der Inspektionseinrichtung vorhanden sind.

Ein Bildschirm als Ausgabemittel, auf welchem gemessene Werte einer geometrischen Eigenschaft, die außerhalb ihres absoluten Toleranzbereichs liegen, durch die Art der Darstellung, insbesondere durch die Farbe, gegenüber gemessenen Werten anderer geometrischer Eigenschaften, die innerhalb ihres absoluten Toleranzbereichs liegen, hervorgehoben sind, hat den Vorteil, daß die Aufmerksamkeit des Bedieners direkt auf mögliche Fehler gelenkt wird.

Durch Eingabemittel, mit welchen von einem Bediener vorgebbar ist, ob ein gemessener Wert einer geometrischen Eigenschaft, der außerhalb des absoluten Toleranzbereichs liegt, als Fehler bewertet werden soll oder nicht, und durch eine derart ausgestaltete Recheneinheit, daß im Falle der Bewertung als kein Fehler der absolute Toleranzbereich der geometrischen Eigenschaft entsprechend dem gemessenen Wert angepaßt wird, wird in vorteilhafter Weise eine automatische Korrektur der Grenzwerte erreicht. Damit ist eine leichte Anpaßbarkeit der Prüfung an geänderte Parameter eines Herstellungsprozesses gewährleistet. Der Bediener wird von der manuellen Eingabe vieler Zahlen beim Einrichtvorgang entlastet. Die neuen Grenzwerte können darauffolgenden Inspektionsschritten zugrunde gelegt werden.

Zur Verbesserung der Entscheidungsgrundlage für die subjektive Beurteilung durch den Bediener kann ein Höhenbild der zu inspizierenden Oberflächenstruktur mit dem optischen Sensor aufgenommen und auf dem Bildschirm dargestellt werden. Ein derartiges Höhenbild zeichnet sich durch eine gute Anschaulichkeit aus. Der Bediener hat somit Zugriff auf die gesamte, im Höhenbild enthaltene Information und eine bessere Grundlage für seine Entscheidung, als wenn die Entscheidung nur auf den mit Hilfe von Bildauswerteverfahren gemessenen Werten der optischen Eigenschaften der zu inspizierenden Oberflächenstruktur beruhen würde.

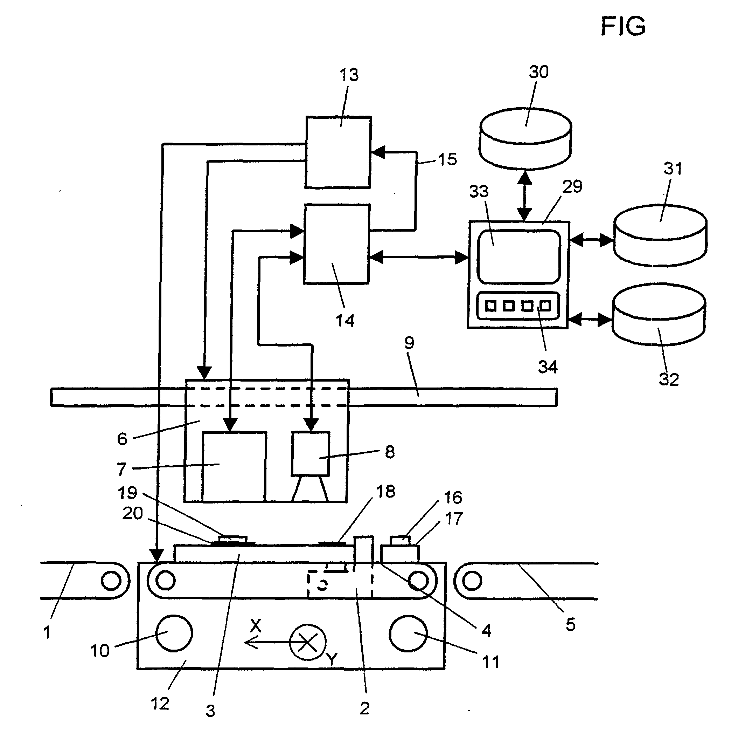

Anhand der Figur, in der ein Ausführungsbeispiel der Erfindung dargestellt ist, werden im folgenden die Erfindung sowie Ausgestaltungen und Vorteile näher erläutert.

Eine Inspektionseinrichtung, deren prinzipieller Aufbau in der Figur dargestellt ist, kann in eine Leiterplattenfertigungslinie eingegliedert werden. Die ungeprüften Leiterplatten werden der Inspektionseinrichtung mit einem Transportband 1 zugeführt. Mit einem abkippbaren Stopper 2, dessen verdeckte Teile mit durchbrochenen Linien gezeichnet sind, wird eine jeweils zu inspizierende Leiterplatte 3 in einer Inspektionsposition gehalten. Nach erfolgter Inspektion wird der Stopper 2 nach unten versenkt und die Leiterplatte 3 wird mit einem Transportband 4 aus der Inspektionseinrichtung heraus und mit einem Transportband 5 zu weiteren, in der Zeichnung nicht dargestellten Bearbeitungsstationen transportiert.

In der Praxis werden üblicherweise mehrere Leiterplatten in einem Nutzen zusammengefaßt und gemeinsam mit einem Transportmittel in der Fertigungslinie bewegt. Der besseren Übersichtlichkeit wegen ist in der Figur auf die Darstellung eines Transportmittels mit einem Leiterplattennutzen verzichtet worden.

Die Achsen der Maschinenkoordinaten der Inspektionseinrichtung sind mit Pfeilen X und Y angedeutet. Der Pfeil Y steht rechtwinklig auf dem Pfeil X und zeigt senkrecht in die Zeichnungsebene hinein. Über der Leiterplatte 3 befindet sich eine Sensoreinheit 6, in welcher ein optischer Sensor 7, der als konfokales Mikroskop ausgeführt ist, und eine CCD-Kamera 8 zusammengefaßt sind. Damit die Sensoreinheit 6 über beliebigen Stellen der Leiterplatte 3 zur Inspektion der zu inspizierenden Merkmale positionierbar ist, kann sie auf einer Führungsachse 9 in X-Richtung verfahren werden. Die Leiterplattenaufnahme ist auf einem Wagen 12 angeordnet, der auf zwei Achsen 10 und 11 in Y-Richtung verfahrbar gelagert ist. In der Zeichnung nicht dargestellte Antriebsmotoren der Sensoreinheit 6 und des Wagens 12 werden durch eine Lagesteuerung 13 derart angesteuert, daß sie von einem Steuerrechner 14 vorgegebene Lagesollwerte 15 anfahren. Lagesteuerung 13, Wagen 12 und die jeweiligen Führungsachsen 9 bzw. 10 und 11 bilden somit eine Positioniereinrichtung, mit deren Hilfe Sensoreinheit 6 und Prüfling 3 bezüglich der X/Y-Koordinaten relativ zueinander beliebig positionierbar sind. Zur Kalibrierung der Inspektionseinrichtung ist am Wagen 12 eine Kalibriermarke 16 vorgesehen, die somit unabhängig vom Prüfling 3 fest mit der Inspektionseinrichtung verbunden ist. Die Kalibriermarke 16 ist als ein auf einer Ebene 17 stehender Zylinder ausgeführt, dessen Durchmesser in diesem Ausführungsbeispiel 1 mm beträgt und der 0,4 mm über die Ebene 17 hinausragt. Die obere Kreisfläche der Kalibriermarke 16 ist für einen besseren Kontrast der Grauwerte geschwärzt. Anhand der Kalibriermarke 16 und einer Kreuzmarke 18, die sich auf der Leiterplatte 3 befindet, sowie einer weiteren Kreuzmarke im linken hinteren Bereich der Leiterplatte 3, die in der Zeichnung nicht dargestellt ist, können der optische Sensor 7 und die CCD-Kamera 8 nach erfolgter Kalibrierung exakt über den zu inspizierenden Merkmalen positioniert und die geometrischen Abmessungen und die Lage der Merkmale vermessen werden. Als Beispiel einer derartigen zu inspizierenden Oberflächenstruktur ist auf der Leiterplatte 3 ein Lotdepot 19 dargestellt, das auf ein metallisches Lötpad 20 beim Lotpastenauftrag aufgebracht worden ist. Eine Recheneinheit 29, die mit einer Bildschirmanzeige 33 und einer Eingabetastatur 34 versehen ist, dient zur Bedienung der Inspektionseinrichtung während der Kalibrierung, während der Feinjustierung sowie während des eigentlichen Inspektionsvorgangs. Auf der Bildschirmanzeige 33 können Zustände der Inspektionseinrichtung sowie Inspektionsergebnisse angezeigt und mit der Eingabetastatur 34 erforderliche Bedieneingaben vorgenommen werden.

In einem ersten Speicher 30 sind Sollwerte für geometrische Eigenschaften der zu inspizierenden Oberflächenstruktur abgelegt. In diesem Ausführungsbeispiel handelt es sich dabei unter anderem um Daten der Pads, beispielsweise des Pads 20, die mittels eines CAD-Umsetzers aus den CAD-Daten der Leiterplatte 3 gewonnen werden können. Da die Dicke der für den Lotpastenauftrag verwendeten Siebdruckschablone üblicherweise nicht aus CAD-Daten entnehmbar ist, wird diese durch einen Bediener als Parameter über die Eingabetastatur 34 eingegeben. Ebenso werden eventuell erforderliche Verkleinerungsfaktoren für die Schablonenöffnungen eingegeben. Zusätzlich wird für die Parametrierung der Bildverarbeitungsalgorithmen eine Angabe der Dicke des Lötstopplacks benötigt. Anhand dieser Angabe kann ein Kantensuchalgorithmus beispielsweise zwischen einer Kante einer Anschlußfläche und einer Kante des Lötstopplacks unterscheiden. Anhand der Pad-Daten und der manuell eingegebenen Werte werden die theoretischen Kenngrößen für Fläche, Höhe, Volumen und Bedeckungsgrad des Lotpastenauftrags auf den Pads als Sollwerte errechnet.

In einem zweiten Speicher 31 sind Werte zur Angabe des relativen Toleranzbereichs für die geometrischen Eigenschaften abgelegt. Diese Werte sind den einzelnen theoretischen Kenngrößen zugeordnet. Aus den Sollwerten im Speicher 30 und den Werten der relativen Toleranzbereiche im Speicher 31 berechnet die Recheneinheit 29 Grenzwerte absoluter Toleranzbereiche, die in einem dritten Speicher 32 abgelegt werden.

Die Speicher 30, 31 und 32 sind zur besseren Anschaulichkeit getrennt dargestellt. Sie können sich in der Praxis selbstverständlich auf demselben Speichermedium befinden.

Zur Vereinfachung des Dialogs für die Eingabe der Schablonendaten wird auf der Bildschirmanzeige 33 der Recheneinheit 29 eine Maske ausgegeben, die Eingabefelder für die Schablonendicke in der Einheit Mikrometer, die Dicke des Lötstopplacks in der Einheit Mikrometer, einen Verkleinerungsfaktor der Schablonendurchbrüche in X-Richtung, einen Verkleinerungsfaktor der Schablonendurchbrüche in Y-Richtung, einen Mittenversatz der Schablonendurchbrüche in X-Richtung in der Einheit Mikrometer und einen Mittenversatz der Schablonendurchbrüche in Y-Richtung in der Einheit Mikrometer enthält. Die manuell eingegebenen Schablonendaten werden zur Berechnung der theoretischen Kenngrößen des Lotpastenauftrags herangezogen. Eine dabei verwendete Hilfsgröße ist die Padfläche, die sich beispielsweise bei einem rechteckigen Pad als Produkt von Padbreite und Padlänge ergibt. Die Fläche des Lotpastenauftrags auf einem Pad wird berechnet als das Produkt aus Padbreite, Verkleinerungsfaktor in Y-Richtung, Padlänge und Verkleinerungsfaktor in X-Richtung. Das Volumen des Lotpastenauftrags wird berechnet als Produkt der Fläche und der Schablonendicke. Ein absoluter Versatz des Lotpastenauftrags in X-Richtung ist gleich dem Betrag des eingegebenen Mittenversatzes der Schablonendurchbrüche in X-Richtung, ein absoluter Versatz in Y-Richtung entspricht dem eingegebenen Betrag des Mittenversatzes in Y-Richtung. Zusätzlich wird als theoretischer Sollwert ein relativer Versatz in X-Richtung berechnet, der sich als Quotient aus dem eingegebenen Betrag des Mittenversatzes in X-Richtung und der Padlänge ergibt. Ein relativer Versatz in Y-Richtung wird als Quotient aus dem eingegebenen Betrag des Mittenversatzes in Y-Richtung und der Padbreite berechnet. Ein Bedeckungsgrad des Pads wird als Quotient aus der Fläche des Lotpastenauftrags und der Padfläche berechnet.

Aus den so ermittelten Sollwerten, die im Speicher 30 abgelegt sind, und Werten der relativen Toleranzbereiche im Speicher 31 berechnet die Recheneinheit 29 in folgender Weise die Werte der absoluten Toleranzbereiche, die im Speicher 32 hinterlegt werden: Ein unterer Grenzwert der Lotpastenfläche ist gleich dem Produkt aus dem Sollwert der Pastenfläche und dem unteren Grenzwert des relativen Toleranzbereichs, welcher der Pastenfläche zugeordnet ist. Entsprechend wird ein oberer Grenzwert der Pastenfläche als das Produkt aus Sollwert der Pastenfläche und oberem Grenzwert des relativen Toleranzbereichs für die Pastenfläche berechnet. In analoger Weise werden absolute Toleranzbereiche für Höhe in Abhängigkeit der Schablonendicke und Volumen in Abhängigkeit des Sollwerts des Pastenvolumens ermittelt. Ein oberer Grenzwert für den absoluten Versatz in X-Richtung wird als Summe des Sollwerts des absoluten Versatzes in X-Richtung und des Produkts aus der Padlänge und einem relativen Toleranzwert des Versatzes berechnet. Entsprechend wird ein oberer Grenzwert für den absoluten Versatz in Y-Richtung als Summe des Sollwerts des absoluten Versatzes in Y-Richtung und des Produkts aus Padbreite und einem relativen Toleranzwert des Versatzes ermittelt. Ein oberer und ein unterer Grenzwert des Bedeckungsgrads wird aus dem Sollwert des Bedeckungsgrads und den zugeordneten relativen Toleranzbereichen erhalten.

Infolge der vorher nicht bekannten Streuung des Herstellungsprozesses der Leiterplatte 3 müssen die - wie oben beschrieben - theoretisch errechneten Grenzwerte der absoluten Toleranzbereiche, die im Speicher 32 abgelegt wurden, für die Inspektion des Lotpastenauftrags noch fein eingestellt werden. Bei dieser Feineinstellung werden mit der Inspektionseinrichtung die einzelnen zu inspizierenden Oberflächenstrukturen angefahren und vermessen. Wird aufgrund einer Überschreitung des absoluten Toleranzbereichs einer geometrischen Eigenschaft, z. B. des Volumens des Lotpastenauftrags auf einem Pad, durch die Inspektionseinrichtung ein Fehler detektiert, so wird das Auftreten eines Fehlers auf der Bildschirmanzeige gemeldet. Zusätzlich kann ein Bediener durch Drücken eines Knopfes "Fehler anzeigen" veranlassen, daß die gemessenen Werte der geometrischen Eigenschaften und das aufgenommene Höhenbild sowie das Grauwertbild des Lotpastenauftrags auf der Bildschirmanzeige 33 dargestellt werden. Die gemessenen Werte, welche die Grenzwerte des absoluten Toleranzbereichs überschreiten, werden durch eine Darstellung mit roter Farbe gegenüber den ansonsten grün angezeigten Werten hervorgehoben, so daß die Aufmerksamkeit des Bedieners direkt auf diese Werte gezogen wird. Anhand der angezeigten gemessenen Werte und Bilder kann der Bediener entscheiden, ob es sich bei dem detektierten Fehler um einen Pseudofehler oder einen tatsächlichen Fehler handelt. Ein Fehler wird als Pseudofehler bezeichnet, wenn die gemessenen Werte der geometrischen Eigenschaft zwar außerhalb der Grenzwerte des absoluten Toleranzbereichs liegen, aber aufgrund der Streuung des Herstellungsprozesses dennoch als gut bezeichnet werden müssen. Seine Entscheidung teilt der Bediener durch einen Knopf "Fehler bestätigen" oder einen Knopf "Fehler ignorieren" auf der Eingabetastatur 34 der Recheneinheit 29 der Inspektionseinrichtung mit. Durch Betätigen eines dieser Knöpfe werden ein Fehlerzähler "Pseudofehler" bzw. ein Fehlerzähler "tatsächliche Fehler" angesteuert. Zusätzlich wird beim Betätigen des Knopfes "Fehler ignorieren", d. h. wenn es sich bei dem detektierten Fehler um einen Pseudofehler handelt, der bisher im Speicher 32 abgelegte Grenzwert des absoluten Toleranzbereichs, der durch den gemessenen Wert überschritten wurde, nach einer Plausibilitätsprüfung als neue Grenzwerteinstellung des jeweiligen absoluten Toleranzbereichs in den Speicher 32 übernommen. Eine umständliche manuelle Eingabe neuer Grenzwerte durch den Bediener ist somit nicht erforderlich. Diesem Pseudofehler entsprechende Meßwerte werden künftig durch die Inspektionseinrichtung toleriert. Damit wurde eine Möglichkeit zum halbautomatischen Trainieren der Inspektionseinrichtung geschaffen, das einen Bediener weitestgehend von manuellen Eingaben entlastet und bei welchem er nur noch zwischen Pseudofehlern und tatsächlichen Fehlern unterscheiden muß. Die Korrektur der im Speicher 32 abgelegten Werte des absoluten Toleranzbereichs wird durch die Recheneinheit 29 automatisch in der richtigen Weise vorgenommen.

## Patentansprüche

1. Einrichtung zur Inspektion einer dreidimensionalen Oberflächenstruktur eines im wesentlichen ebenen Prüflings, insbesondere zur Inspektion des Lotpastendrucks auf Leiterplatten,
- mit einem optischen Sensor (7) zur dreidimensionalen Erfassung zumindest eines Teilbereichs der Oberfläche des Prüflings (3) und
- mit einer Positioniereinrichtung (9 ... 13), mit welcher der optische Sensor (7) und der Prüfling (3) relativ zueinander positionierbar sind,
**dadurch gekennzeichnet,**
- **daß** in einem ersten Speicher (30) Sollwerte für geometrische Eigenschaften der zu inspizierenden Oberflächenstruktur abgelegt sind,
- **daß** in einem zweiten Speicher (31) Werte zur Angabe des relativen Toleranzbereichs für die geometrischen Eigenschaften abgelegt sind,
- **daß** eine Recheneinheit (29) vorhanden ist zur Berechnung von Grenzwerten eines absoluten Toleranzbereichs und
- **daß** Mittel zur Anzeige eines Fehlers vorhanden sind, wenn ein gemessener Wert einer geometrischen Eigenschaft einer inspizierten Oberflächenstruktur nicht innerhalb ihres absoluten Toleranzbereichs liegt.

2. Einrichtung nach Anspruch 1, **dadurch gekennzeichnet,**
- **daß** die zu inspizierende Oberflächenstruktur ein Lotpastenauftrag (19) auf einer Anschlußfläche (20), einem sogenannten Pad, für einen Bauelementeanschluß auf einer Leiterplatte (3) ist und
- **daß** die geometrischen Eigenschaften die Fläche, die Höhe, das Volumen des Lotpastenauftrags (19) und/oder der Versatz des Lotpastenauftrags (19) gegenüber dem Pad (20) sind.

3. Einrichtung nach Anspruch 1 oder 2, **dadurch gekennzeichnet,**
- **daß** Mittel (33) zur Ausgabe der gemessenen Werte der geometrischen Eigenschaften einer inspizierten Oberflächenstruktur vorhanden sind.

4. Einrichtung nach Anspruch 3, **dadurch gekennzeichnet,**
- **daß** ein Ausgabemittel (33) ein Bildschirm ist, auf welchem gemessene Werte einer geometrischen Eigenschaft, die außerhalb ihres absoluten Toleranzbereichs liegen, durch die Art der Darstellung, insbesondere durch die Farbe, gegenüber gemessenen Werten anderer geometrischer Eigenschaften, die innerhalb ihres absoluten Toleranzbereichs liegen, hervorgehoben sind.

5. Einrichtung nach Anspruch 3 oder 4, **dadurch gekennzeichnet,**
- **daß** ein Eingabemittel (34) vorgesehen ist, mit welchem von einem Bediener vorgebbar ist, ob ein gemessener Wert einer geometrischen Eigenschaft, der außerhalb des absoluten Toleranzbereichs liegt, als Fehler bewertet werden soll oder nicht, und
- **daß** die Recheneinheit (29) derart ausgestaltet ist, daß im Falle einer Bewertung als kein Fehler der absolute Toleranzbereich der Werte der geometrischen Eigenschaft entsprechend dem gemessenen Wert angepaßt wird.

6. Einrichtung nach einem der vorhergehenden Ansprüche,
**dadurch gekennzeichnet,**
- **daß** der optische Sensor (7) ein Höhenbild der zu inspizierenden Oberflächenstruktur aufnimmt und
- **daß** auf der Bildschirmanzeige (33) das Höhenbild und/oder ein Grauwertbild darstellbar ist.

## Claims

1. Device for inspecting a three-dimensional surface structure of a substantially flat test-piece, particularly for inspecting the solder paste print on printed circuit boards,
- having an optical sensor (7) for the three-dimensional sensing of at least one sub-region of the surface of the test-piece (3) and
- having a positioning device (9 ... 13), by means of which the optical sensor (7) and the test-piece (3) can be positioned relative to one another,
**characterized in that**
- setpoint values for geometric characteristics of the surface structure to be inspected are stored in a first memory (30),
- values for the definition of the relative tolerance range for the geometric characteristics are stored in a second memory (31),
- there is a computing unit (29) for the calculation of limiting values of an absolute tolerance range, and
- there are means for displaying a fault if a measured value of a geometric characteristic of an inspected surface structure does not lie within its absolute tolerance range.

2. Device according to Claim 1, **characterized in that**
- the surface structure to be inspected is a solder paste application (19) on a terminal connection area (20), a so-called pad, for a component terminal connection on a printed circuit board (3), and
- the geometric characteristics are the area, the height, the volume of the solder paste application (19) and/or the offset of the solder paste application (19) in relation to the pad (20).

3. Device according to either of Claims 1 or 2,
**characterized in that**
- there are means (33) for outputting the measured values of the geometric characteristics of an inspected surface structure.

4. Device according to Claim 3, **characterized in that**
- an output means (33) is a display screen on which measured values of a geometric characteristic which lie outside their absolute tolerance range are highlighted, relative to measured values of other geometric characteristics which lie inside their absolute tolerance range, by the type of representation, particularly by the colour.

5. Device according to either of Claims 3 or 4,
**characterized in that**
- an input means (34) is provided by means of which an operator can define whether a measured value of a geometric characteristic lying outside the absolute tolerance range is to be evaluated as a fault or not, and
- the computing unit (29) is of such design that, in the case of an evaluation as no fault, the absolute tolerance range of the values of the geometric characteristic is adapted according to the measured value.

6. Device according to any one of the preceding Claims,
**characterized in that**
- the optical sensor (7) captures a height image of the surface structure to be inspected, and
- the height image and/or the grey-scale image can be represented on the display screen (33).

## Revendications

1. Dispositif pour l'inspection d'une structure superficielle tridimensionnelle d'une ébauche essentiellement plane, en particulier pour l'inspection d'une pâte à braser appliquée sur des cartes à circuits imprimés, comportant
- un capteur optique (7) pour la détection tridimensionnelle d'au moins une zone partielle de la surface de l'ébauche (3), et
- un dispositif de positionnement (9 ... 13), à l'aide duquel le capteur optique (7) et l'ébauche (3) peuvent être positionnés l'un par rapport à l'autre,
**caractérisé en ce que**
- dans une première mémoire (30) sont déposées des valeurs prescrites des propriétés géométriques de la structure superficielle à inspecter,
- dans une deuxième mémoire (31) se trouvent des valeurs destinées à indiquer la gamme de tolérance relative des propriétés géométriques,
- une unité de calcul (29) est présente, pour le calcul des valeurs limites d'une gamme de tolérance absolue, et
- des moyens sont prévus pour afficher un défaut quand une valeur mesurée d'une propriété géométrique d'une structure superficielle inspectée ne se trouve pas à l'intérieur de sa gamme de tolérance absolue.

2. Dispositif selon la revendication 1, **caractérisé en ce que**
- la structure superficielle à inspecter est une masse de pâte à braser (19) appliquée sur une surface de connexion (20), ce que l'on appelle un plot, pour une connexion de composants sur une carte à circuits imprimés (3), et
- les propriétés géométriques sont l'aire, la hauteur, le volume de la pâte à braser appliquée (19), et/ou le déport de la pâte à braser appliquée (19) par rapport au plot (20).

3. Dispositif selon la revendication 1 ou 2, **caractérisé en ce que**
- des moyens (33) sont présents, pour donner en sortie les valeurs mesurées des propriétés géométriques d'une structure superficielle inspectée.

4. Dispositif selon la revendication 3, **caractérisé en ce qu'**un moyen de sortie (33) est un écran sur lequel les valeurs mesurées d'une propriété géométrique situées à l'extérieur de leur gamme de tolérance absolue sont soulignées par la nature de leur représentation, en particulier par leur couleur, par rapport aux valeurs mesurées d'autres propriétés géométriques, qui se trouvent à l'intérieur de leur gamme de tolérance absolue.

5. Dispositif selon la revendication 3 ou 4, **caractérisé en ce que**
- un moyen d'entrée (34) est prévu, à l'aide duquel un opérateur peut indiquer au préalable si une valeur mesurée d'une propriété géométrique se trouvant à l'extérieur de la gamme de tolérance absolue doit être, ou non, considérée comme un défaut, et
- l'unité de calcul (29) est configurée de telle sorte que, quand l'évaluation indique l'absence de défaut, la gamme de tolérance absolue des valeurs de la propriété géométrique soit adaptée en fonction de la valeur mesurée.

6. Dispositif selon l'une des revendications précédentes,
**caractérisé en ce que**
- le capteur optique (7) enregistre un profil de la structure superficielle à inspecter, et
- le profil et/ou une image des gris peuvent être représentés sur l'écran (33).
